# EUROPÄISCHE PATENTANMELDUNG

(11) **EP 1 292 028 A2**
(43) Veröffentlichungstag der Anmeldung: **12.03.2003**
(21) Anmeldenummer: 02015969.5
(22) Anmeldetag: 18.07.2002
(51) Int. Cl.: H03K 17/94

(54) **Signalerzeugungs- und Korrekturschaltung und Verfahren zur Korrektur von digitalen Signalen**

(30) Priorität: 18.08.2001 DE 10139204
(71) Anmelder: PWB-Ruhlatec Industrieprodukte GmbH, 99846 Seebach (DE)
(72) Erfinder: Tenca, Vittorio, 37013 Caprino Veronese (VR) (IT); Zanotti, Ernesto, 37057 S. Giovanni Lupatoto (VR) (IT); Bari, Andrea, 37126 Verona (IT); Corradori, Corrado, 37026 Pescantina (VR) (IT)
(74) Vertreter: Müller-Wolff, Thomas, Dipl.-Ing.

(57) **Zusammenfassung**

Eine Signalerzeugungs- und Korrekturschaltung besteht aus einer LED-Diode D1 und einem Phototransistor Q1 mit zugehörigen Ein- und Ausgängen d1e, d1a und q1e, q1a sowie aus Verbindungsleitungen 1, 2 zu Stromanschlüssen A, B. Die Ein- und Ausgänge d1e, d1a und q1e, q1a der Diode D1 und der Photozelle Q1 sind zu einer Parallelschaltung verbunden, wobei in der Phototransistorleitung 3 zwischen dem Ausgang q1a und dem Knotenpunkt K mit der Verbindungsleitung 2 ein Widerstand R2 uns zwischen dem Knotenpunkt K und dem Stromanschluß B ein Widerstand R1 in der Leitung 2 angeordnet ist. Ein Transistor Q2 ist mit seiner Basis q2b an den Ausgang q1a oder der Phototransistorleitung 3 angeschlossen. Der Kontrollstrom weist den Wert 0 auf, wenn im Phototransistor Q1 ein Photostrom fließt, während auf der Emitterseite q2e des Transistors Q2 ein Signal mit konstanter, einstellbarer Größe erzeugt wird, wenn kein Photostrom fließt.

## Beschreibung

Die Erfindung betrifft eine Signalerzeugungs- und Korrekturschaltung, bestehend aus einer LED-Diode und einer Photozelle mit zugehörigen Ein- und Ausgängen sowie aus Verbindungsleitungen zu Stromanschlüssen sowie ein Verfahren zur Korrektur von digitalen Signalen.

Für die Signalerzeugung werden einfache Phototransistoren und aufwendigere Maskensensoren eingesetzt. Diese unterscheiden sich in dem Ausgangssignal, wobei Signalerzeuger auf der Basis einfacher Phototransistoren keine exakten Signalwerte im ausgeschalteten (OFF) Zustand und bei maximaler Stromdurchleitung ermöglichen.

So werden bei den bisher verwendeten einfachen Phototransistoren mit Taktscheibengesteuerung durch die Umgebungsstrahlung und durch die besondere Charakteristik der Taktscheibe stets Minimumspannungswerte von mindestens 0,1 mV entsprechend 0,1 mA Mindeststrom bei einem Widerstandswert von 1000 Ohm benötigt. Diese Werte liegen für hochwertige Einsatzgebiete, wie beispielsweise einer Computer-Maus außerhalb der zulässigen Toleranz.

Es besteht deshalb die Aufgabe, eine Signalerzeugungs- und Korrekturschaltung anzugeben, mit der unter Verwendung einfacher Phototransistoren eine mindestens gleichwertige Qualität des Ausgangssignals wie bei Maskensensoren zu erzielen ist. Darüber hinaus soll ein Verfahren zur Signalkorrektur angegeben werden, mit dem sich mit vorhandenen, einfachen Phototransistoren, insbesondere unter Verwendung von Taktscheiben bzw. Encodern bekannter Bauart ein konstantes Ausgangssignal mit geringer Toleranzbreite erzeugen läßt.

Diese Aufgabe wird erfindungsgemäß durch die in den Patentansprüchen angegebenen Merkmale gelöst.

Im Prinzip besteht die erfindungsgemäße Signalerzeugungs- und Korrekturschaltung aus einer LED-Diode D1, deren Licht in einem parallel zur Diode D1 geschalteten Phototransistor Q1 einen Photostrom auslöst. Sobald der Photostrom fließt, wird der am Kollektor des Phototransistors Q1 anliegende Strom durchgeleitet und fließt über einen Widerstand R2 über einen Knotenpunkt zur Verbindungsleitung 2 zurück.

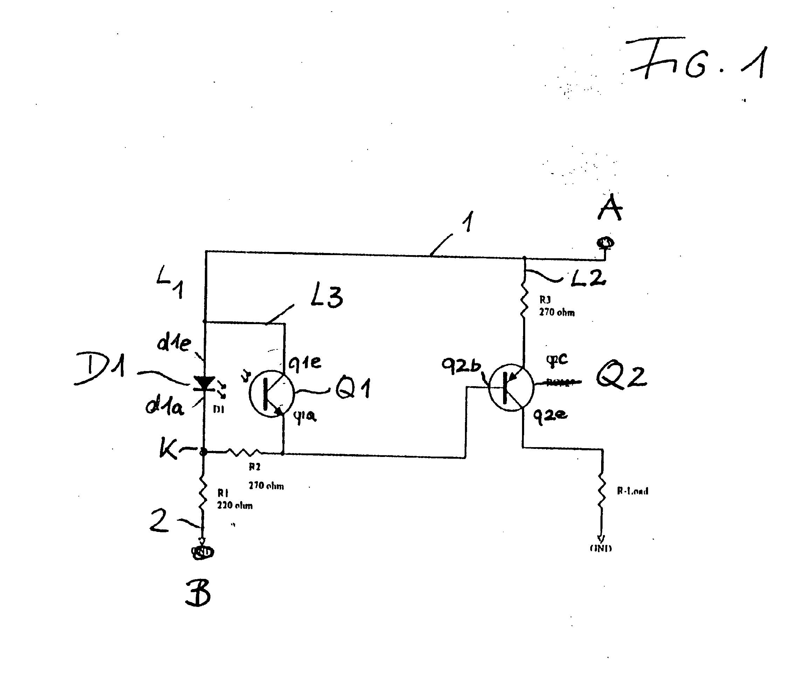

Wie in Figur 1 dargestellt, ist ein Transistor Q2 kollektorseitig über einen Widerstand R3 mit der Verbindungsleitung 1 und über den Basisanschluß mit der Phototransistorleitung 3 des Phototransistors Q1 verbunden. Somit wird- wenn kein Photostrom im Phototransistor Q1 fließt - der Strom über den Widerstand R3 und den Transistor Q2 geleitet, da der Reststrom über den Widerstand R1 fließt und dadurch die Sperrung des Transistors Q2 aufgehoben wird.

Das Ausgangssignal des Transistors Q2 ist über den Widerstand R3 einstellbar und kann durch die erfindungsgemäße Schaltung innerhalb enger Grenzen konstant gehalten werden. In Versuchen wurde festgestellt, daß bei Spannungswerten von beispielsweise 2,6 V ein maximaler Fehler von 0,01 V auftrat. Dies gilt in entsprechender Weise für die Stromwerte, wobei der Minimumstromwert nahe 0 mA lag.

Insgesamt war eine hohe Gleichförmigkeit der erzeugten Signale bei sehr guter Einstellbarkeit zwischen dem unteren und oberen Maximalwert feststellbar. Durch die niedrigen Kosten der eingesetzten Bauteile erschließen sich viele Anwendungsmöglichkeiten bei der Signalerzeugung und Signalformung im Digitalbereich. Anstelle des hier beschriebenen Beispieles mit einem Phototransistor können auch mehrere parallelgeschaltete Phototransistoren verwendet werden, um mehr Strom in der Phototransistorleitung 3 zu erzeugen. Es ist auch möglich, diese Signalerzeugung oder Signalformung mit weiteren Signalformungseinrichtungen, wie z.B. Rechtecksignalformern zu verbinden. Hierfür sind bestimmte Spannungsniveaus einzuhalten, beispielsweise muß für das 0-Niveau eine Spannung von 0,2 bis 0,4 V und für das Maximumniveau eine Spannung von 1,8 bis 2,5 V eingehalten werden.

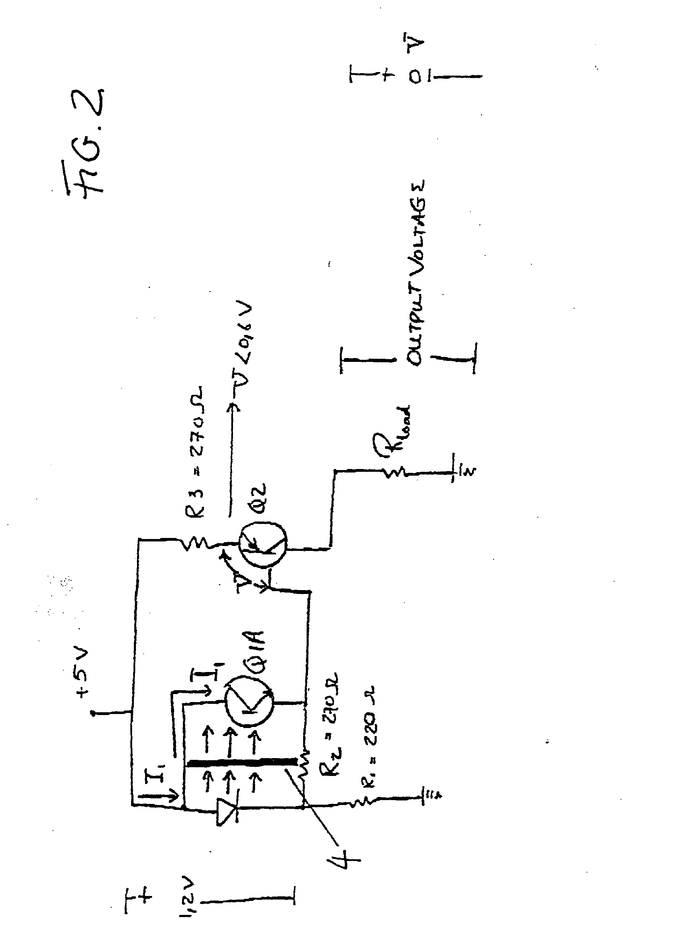

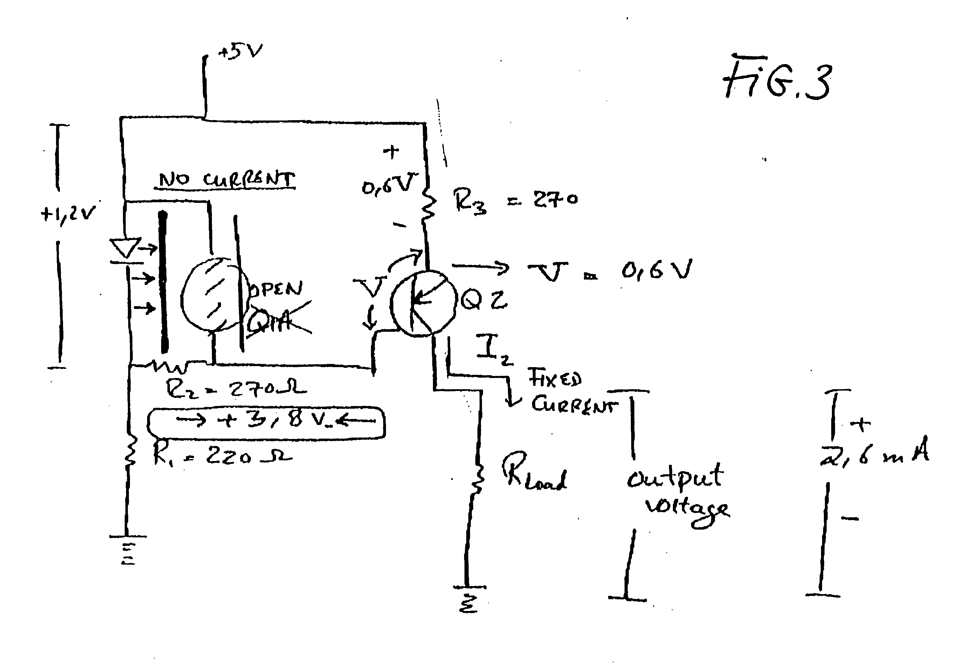

Die Figuren 2 und 3 zeigen den Stromfluß für den Fall einer beleuchteten Phototransistorbasis (Figur 2) und einer verdunkelten Phototransistorbasis (Figur 3). In beiden Figuren ist schematisch ein Taktscheibe 4 eingezeichnet, um symbolhaft den Vorgang bei der Signalerzeugung darzustellen.

Gemäß Figur 3 geht von der LED-Diode D1 Licht durch die Taktscheibe hindurch und trifft auf die Basis des Phototransistors Q1. Dann wird ein Strom I1 über Q1 an den Widerstand R2 weitergeleitet. Infolgedessen gelangt an den Transistor Q2 kein Strom, da die Basisspannung V nicht überschritten wird. Im Beispiel wird die Basisspannung von 0,6 V nicht erreicht, so daß der Transistor Q2 im ausgeschalteten Zustand (OFF) bleibt und somit auch kein Strom über den Widerstand R_{load} fließt.

In Figur 3 wird das von der LED-Diode D1 ausgesendete Licht von der Taktscheibe unterbrochen, so daß kein Photostrom in den Phototransistor Q1 fließt. Statt dessen fließt der Strom nur über den Widerstand R3 und R1, wobei die Basisspannung V = 0,6 V erreicht wird und eine konstante Stromstärke über R_{load} abfließt. In Figur 3 ist dieser Zustand durch den Pfeil I2 (fixed current) mit einem Stromwert von 2,6 mA angegeben.

## Patentansprüche

1. Signalerzeugungs- und Korrekturschaltung, bestehend aus einer LED-Diode (D1) und einem Phototransistor (Q1) mit zugehörigen Ein- und Ausgängen (d1e, d1a und q1e, q1a) sowie aus Verbindungsleitungen (1, 2) zu Stromanschlüssen (A, B),
**dadurch gekennzeichnet,**
**daß** die Ein- und Ausgänge (d1e, q1e) bzw. (dla und qla) der Diode (D1) und der Photozelle (Q1) zu einer Parallelschaltung verbunden sind, wobei in der Phototransistorleitung (3) zwischen dem Ausgang (qla) und dem Knotenpunkt (K) mit der Verbindungsleitung (2) ein Widerstand (R2) und zwischen dem Knotenpunkt (K) und dem Stromanschluß (B) ein Widerstand (R1) in der Leitung (2) angeordnet ist,
**daß** ein Transistor (Q2) mit seiner Basis (q2b) an den Ausgang (qla) oder der Phototransistorleitung (3) angeschlossen ist, während der Kollektoranschluß (q2c) über einen Widerstand (R3) an die Verbindungsleitung (1) angeschlossen ist,
wobei der Kollektorstrom den Wert 0 aufweist, wenn im Phototransistor (Q1) ein Photostrom fließt, während auf der Emitterseite (q2e) des Transistors (Q2) ein Signal mit konstanter, einstellbarer Größe erzeugt wird, wenn kein Photostrom fließt.

2. Signalerzeugungs- und Korrekturschaltung nach Anspruch 1,
**dadurch gekennzeichnet,**
**daß** der Transistor (Q2) als Stromgenerator geschaltet ist.

3. Signalerzeugungs- und Korrekturschaltung nach einem der vorhergehenden Ansprüche,
**dadurch gekennzeichnet,**
**daß** über den Widerstand (R1) der Spannungsabfall der Diode D1 regelbar ist.

4. Signalerzeugungs- und Korrekturschaltung nach einem der vorhergehenden Ansprüche,
**dadurch gekennzeichnet,**
**daß** der Widerstand (R2) so bemessen ist, daß bei maximalem Photostrom der durch die Phototransistorleitung (3) fließende Strom ausschließlich über den Knotenpunkt (K) in die Verbindungsleitung (2) fließt.

5. Signalerzeugungs- und Korrekturschaltung nach einem der vorhergehenden Ansprüche,
**dadurch gekennzeichnet,**
**daß** die Höhe des Stromausgangssignals am Emitter des Transistors (Q2) über den Widerstand (R3) einstellbar ist.

6. Signalerzeugungs- und Korrekturschaltung nach einem der vorhergehenden Ansprüche,
**dadurch gekennzeichnet,**
**daß** mehrere Phototransistoren (Q1A, Q1B, etc) parallel geschaltet sind.

7. Signalerzeugungs- und Korrekturschaltung nach einem der vorhergehenden Ansprüche,
**dadurch gekennzeichnet,**
**daß** die Verbindungsleitung (1) aufgeteilt ist in Leitungen (L1) zur Diode (D1), (L2) zum Transistor (Q2) und (L3) zum Phototransistor (Q1), dessen Ausgang über eine Leitung (3) sowohl mit der Basis des Transistors (Q2) als auch über einen Widerstand (R2) mit dem Ausgang der Diode (D1) verbunden ist.

8. Signalerzeugungs- und Korrekturschaltung nach einem der vorhergehenden Ansprüche,
**dadurch gekennzeichnet,**
**daß** in der Leitung (L2) ein Widerstand (R3) angeordnet ist, dessen Widerstandsbeiwert dem des Widerstands (R2) entspricht.

9. Signalerzeugungs- und Korrekturschaltung nach einem der vorhergehenden Ansprüche,
**dadurch gekennzeichnet,**
**daß** die Schaltspannung für den Transistor (Q2) höher ist als der Spannungsabfall am Widerstand (R2).

10. Signalerzeugungs- und Korrekturschaltung nach einem der vorhergehenden Ansprüche,
**dadurch gekennzeichnet,**
**daß** in der Spannungsversorgungsleitung (L1) für die Diode (D1) ein Widerstand (R1) angeordnet ist, der einen Spannungsabfall zur Steuerung der Spannungshöhe im Ausgang des Transistors (Q2) verursacht.

11. Verfahren zur Signalerzeugung bzw. Signalkorrektur, wobei in einem parallel zu einer LED-Diode (D1) geschalteten Phototransistor (Q1) ein Photostrom erzeugt wird, mit dem der über die Verbindungsleitungen (1, 2) fließende Kollektorstrom des Phototransistors (Q1) steuerbar ist,
**dadurch gekennzeichnet,**
**daß** parallel zum Phototransistor (Q1) ein Transistor (Q2) als Signalgenerator angeschlossen ist, wobei die Basis des Transistors (Q2) mit der Emitterseite des Phototransistors (Q1) verbunden ist und der Kollektor des Transistors (Q2) über einen Widerstand (R3) an die Verbindungsleitung (1) angeschlossen ist.

12. Verfahren nach dem vorhergehenden Anspruch,
**dadurch gekennzeichnet,**
**daß** über den Widerstand (R3) das Stromverhältnis von Kollektorstrom zu Basisstrom des Transistors (Q2) einstellbar ist.

13. Verfahren nach einem der vorhergehenden Ansprüche,
**dadurch gekennzeichnet,**
**daß** der Spannungsabfall an der Diode (D1) benutzt wird, um eine konstante Generatorspannung zu erzeugen.

14. Verfahren nach einem der vorhergehenden Ansprüche,
**dadurch gekennzeichnet,**
**daß** die Größe des Widerstandes (R2) nach der erforderlichen Vorspannung des Transistors (Q2) bemessen wird.

15. Verfahren nach einem der vorhergehenden Ansprüche,
**dadurch gekennzeichnet,**
**daß** der Widerstand (R1) nach der erforderlichen Vorspannung der LED-Diode (D1) bemessen wird.
